# EUROPÄISCHE PATENTSCHRIFT

(11) **EP 3 393 753 B1**
(45) Veröffentlichungstag und Bekanntmachung des Hinweises auf die Patenterteilung: **24.04.2019**
(21) Anmeldenummer: 16815857.4
(22) Anmeldetag: 20.12.2016
(51) Int. Cl.: B29C 65/00, H01H 9/02, B29C 45/40

(54) **MONOLITISCHE FERNBEDIENUNG**
MONOLITHIC REMOTE CONTROL
TÉLÉCOMMANDE MONOLITHIQUE

(30) Priorität: 23.12.2015 DE 102015016784
(43) Veröffentlichungstag der Anmeldung: 31.10.2018
(73) Patentinhaber: fm marketing gmbh, 5202 Neumarkt am Wallersee (AT)
(72) Erfinder: MAIER, Ferdinand, 5202 Neumarkt am Wallersee (AT)
(74) Vertreter: von Bülow & Tamada
(86) Internationale Anmeldenummer: PCT/EP2016/082031
(87) Internationale Veröffentlichungsnummer: WO 2017/108862

(56) Entgegenhaltungen:
- EP-A2- 1 108 519
- WO-A1-00/00337
- DE-A1-102010 045 944
- US-A1- 2002 079 615
- US-A1- 2006 269 651
- US-A1- 2013 255 875
- US-B1- 7 008 240

## Beschreibung

Die vorliegende Erfindung betrifft ein Kunststoffgehäuse für elektronische Geräte, insbesondere Fernbedienungen.

Ein derartiges Kunststoffgehäuse ist beispielsweise aus der DE 10 2010 045 944 A1 bekannt. Es umfasst ein erstes Gehäuseteil und ein zweites Gehäuseteil, wobei das erste Gehäuseteil eine in Richtung des zweiten Gehäuseteils gerichtete Fügefläche umfasst und das zweite Gehäuseteil eine in Richtung des ersten Gehäuseteils gerichtete Fügefläche umfasst und wobei die beiden Gehäuseteile an den Fügeflächen aneinander anliegend zusammengesetzt sind.

Aus der US 2013 / 255875 A1 und der US 7 008 240 B1 ist je ein Kunststoffgehäuse gemäß dem Oberbegriff des Anspruchs 1 bekannt.

Erfindungsgemäß umfasst ein Kunststoffgehäuse für elektronische Geräte, insbesondere Fernbedienungen, ein erstes Gehäuseteil und ein zweites Gehäuseteil, wobei das erste Gehäuseteil eine in Richtung des zweiten Gehäuseteils gerichtete Fügefläche umfasst und das zweite Gehäuseteil eine in Richtung des ersten Gehäuseteils gerichtete Fügefläche umfasst, wobei die beiden Gehäuseteile den Fügeflächen aneinander anliegend zusammengesetzt sind, wobei die Fügeflächen als Gehrungsflächen ausgeführt sind, und wobei an oder auf den Gehrungsflächen Auflageflächen zur Auflage von Auswerferstiften ausgebildet sind, an denen die Gehäuseteile vertieft sind.

Dem angegebenen Kunststoffgehäuse liegt die Überlegung zugrunde, dass das eingangs genannte Kunststoffgehäuse Formschlusselemente aufweist, die die Fügefläche vergrößern und so den beiden Gehäuseteilen eine breitere Angriffsfläche gegeneinander bieten. Problematisch an den Formschlusselementen ist jedoch, dass diese exakt aufeinander abgestimmt werden müssen, weil sonst zwischen den beiden Gehäuseteilen im zusammengesetzten Zustand des Kunststoffgehäuses ein Spalt verbleibt, der vor allem in Bereichen mit hohen ästhetischen Anforderungen als störend empfunden werden kann. Um diesen Spalt zu vermeiden und zwischen den beiden Gehäuseteilen dennoch eine hohe Fügefläche zu realisieren, wird mit dem angegebenen Kunststoffgehäuse vorgeschlagen, die Fügeflächen als Gehrungsflächen auszuführen.

In einer Weiterbildung des angegebenen Kunstsstoffgehäuses sind die Gehrungsflächen der Gehäuseteile zumindest teilweise umlaufend um einen Innenraum ausgebildet, der eingerichtet ist, eine elektronische Komponente des elektronischen Gerätes einzuhausen. Auf diese Weise verlaufen die Gehrungsflächen V-förmig und erlauben es so, die beiden Gehäuseteile zusätzlich gegeneinander zu zentrieren. Damit erfüllen die Gehrungsflächen gleichzeitig die Funktion der zuvor genannten Formschlusselemente.

In einer zusätzlichen Weiterbildung des angegebenen Kunststoffgehäuses sind die Gehrungsflächen in den Innenraum hinein führend ausgebildet. Auf diese Weise liegen alle stumpfen Kanten an den Gehäuseteilen, die durch die Gehrungsflächen gebildet werden im Innenraum des Kunststoffgehäuses. An den stumpfen Kanten können bei der Herstellung der Gehäuseteile Werkzeuge, wie beispielsweise Ausstoßerstifte, Entlüftungselemente oder dergleichen in besonders günstiger Weise innenraumseitig ansetzen, so dass eventuell verbleibende Grate oder dergleichen im Nachhinein nicht mehr sichtbar sind.

In einer anderen Weiterbildung wird das angegebene Kunststoffgehäuse durch ein Verfahren hergestellt, bei dem ein Urformmaterial in die die Gehäuseteile bildenden Formräume eingeführt und Luft aus dem den Formräumen an Eintlüftungsstellen abgeführt wird, die an oder neben Stellen in den Formräumen liegt, an der die Gehrungsflächen der Gehäuseteile gebildet werden.

Der Weiterbildung liegt die Überlegung zugrunde, dass das Urformmaterial beim Einführen in den Formraum die dort vorhandene Luft verdrängt, so dass die Luft aus dem Formraum abgeführt werden muss. Normalerweise wird die Luft aus dem Formraum an einer Trennebene zwischen den Werkzeugteilen abgeführt, die den Formraum bilden. Damit die Gehrungsflächen und damit die Formteile an der nach außen gerichteten Seite der Fernbedienung möglichst exakt spitz verlaufen, sollten die Trennebenen an dieser Stelle so dicht wie möglich sein, damit kein Urformmaterial in die Trennebene eintritt und so einen als störend wirkenden Grat hinterlässt. Durch diese dichte Ausführung der Trennebenen ist eine Entlüftung des Formraumes an der Trennebene praktisch ausgeschlossen. Daher wird vorgeschlagen, die Entlüftungsstelle an oder neben die Gehrungsfläche, vorzugsweise im zu bildenden Innenraum des Kunststoffgehäuses zu legen, damit die Entlüftung einerseits möglichst nah an der zu bildenden Gehrungsfläche stattfindet und sich so keine als störend empfundenen Verbrennungen, Einschlüsse oder dergleichen bilden können, andererseits aber auch herstellungsbedingte Grate oder dergleichen im zu bildenden Innenraum des Kunststoffgehäuses angeordnet werden.

In einer Weiterbildung des angegebenen Verfahrens werden zum Abführen der Luft aus den Formräumen in die Formräume führende Kanäle genutzt, in denen Auswerferstifte eingeführt sind. Auf diese Weise wird einerseits der Luftkanal sehr klein gehalten, durch den die Luft aus dem Formraum abgeführt wird, so dass nach einer vollständigen Entlüftung des Formraumes auch entsprechend weniger Urformmaterial in den Entlüftungskanal eindringt. Andererseits wird der Entlüftungskanal beim Auswerfen des urgeformten Gehäuseteils automatisch durch den Auswerferstift gereinigt.

In einer weiteren Weiterbildung des angegebenen Kunststoffgehäuses wird das Urformmaterial an Anspritzpunkten in die Formräume eingeführt, die an einer Seite des Formraumes angeordnet ist, der einer Seite mit der Entlüftungsstelle gegenüberliegt.

In einer besonderen Weiterbildung des angegebenen Kunststoffgehäuses sind die Anspritzpunkte in einer Anspritzrichtung des Urformmaterials gesehen mittig in den Formräumen angeordnet. Auf dieser Weise wird sichergestellt, dass sich das Urformmaterial gleichmäßig in alle Richtungen des Formraumes verteilen kann. Zusätzlich ist jedoch auch sicher gestellt, dass das Urformmaterial in die spitzen Bereiche des Formraumes zuletzt eindringt und so dort nicht vorzeitig aushärtet, was den Formraum verstopfen könnte.

In einer noch anderen Weiterbildung des angegebenen Kunststoffgehäuses werden die Formräume mit Formplatten gebildet, die vor dem Einführen des Urformmaterials in die Formräume an einer Trennebene luftdicht verschlossen werden. Auf diese Weise wird der oben genannte Grat an der Trennebene im Formraum vermieden.

In einer bevorzugten Weiterbildung des angegebenen Kunststoffgehäuses münden die Gehrungsflächen der zu bildenden Gehäuseteile in die Trennebene.

In einer besonders bevorzugten Weiterbildung des angegebenen Kunststoffgehäuses liegen die Eintlüftungsstellen an den Gehrungsflächen der Trennebene gegenüber. Auf diese Weise ist sichergestellt, dass durch die Entlüftung entstehende Grate oder dergleichen im zu bildenden Innenraum des Kunststoffgehäuses angeordnet werden und von außen nicht sichtbar sind.

Gemäß einem weiteren Aspekt der Erfindung wird in einem Verfahren zum Herstellen eines Gehäuseteiles, für eines der angegebenen Kunststoffgehäuse ein Urformmaterial in einen das Gehäuseteil bildenden Formraum eingeführt und Luft aus dem Formraum an einer Eintlüftungsstelle abgeführt, die an oder neben einer Stelle im Formraum liegt, an der die Gehrungsfläche des Gehäuseteils gebildet wird.

In einer Weiterbildung des angegebenen Verfahrens wird zum Abführen der Luft aus dem Formraum ein in den Formraum führender Kanal genutzt, in den ein Auswerferstift eingeführt ist.

In einer anderen Weiterbildung des angegebenen Verfahrens wird das Urformmaterial an einem Anspritzpunkt in dem Formraum eingeführt, der an einer Seite des Formraumes angeordnet ist, der einer Seite mit der Entlüftungsstelle gegenüberliegt.

In einer zusätzlichen Weiterbildung des angegeben Verfahrens der Anspritzpunkt dabei auf einer Mittelachse des Formraumes angeordnet.

In einer noch anderen Weiterbildung des angegebenen Verfahrens wird der Formraum über zwei Werkzeugformen gebildet, die vor dem Einführen des Urformmaterials in den Formraum an einer Trennebene luftdicht verschlossen werden.

In einer besonderen Weiterbildung des angegebenen Verfahrens münden die Gehrungsfläche des zu bildenden Gehäuseteils in die Trennebene.

In einer besonders bevorzugten Weiterbildung des angegebenen Verfahrens liegt die Eintlüftungsstelle an der Gehrungsfläche der Trennebene gegenüber.

Gemäß einem weiteren Aspekt der Erfindung ist ein Gehäuseteil eines der angegebenen Kunststoffgehäuse mit einem der angegebenen Verfahren hergestellt.

Die oben beschriebenen Eigenschaften, Merkmale und Vorteile dieser Erfindung sowie die Art und Weise wie diese erreicht werden, werden verständlicher im Zusammenhang mit der folgenden Beschreibung der Ausführungsbeispiele, die im Zusammenhang mit der Zeichnung näher erläutert werden. Es zeigen:
Fig. 1 eine Fernbedienung in einer perspektivischen Ansicht,
Fig. 2a bis 2c Ausschnitte von Schnittansichten eines Urformwerkzeuges zur Herstellung eines ersten Gehäuseteils für ein Kunststoffgehäuse der Fernbedienung der Fig. 1,
Fig. 3a bis 3c Ausschnitte von Schnittansichten eines Urformwerkzeuges zur Herstellung eines zweiten Gehäuseteils für das Kunststoffgehäuse der Fernbedienung der Fig. 1,
Fig. 4 eine perspektivische Ansicht eines Teils eines Urformwerkzeugs zur Herstellung des Kunststoffgehäuses für die Fernbedienung der Fig. 1,
Fig. 5 eine Teilansicht des Teils des Urformwerkzeugs der Fig. 4 aus einer anderen Perspektive,
Fig. 6 eine perspektivische Ansicht eines weiteren Teils des Urformwerkzeugs zur Herstellung des Kunststoffgehäuses für die Fernbedienung der Fig. 1,
Fig. 7a und 7b Schnittansichten des Kunststoffgehäuses der Fernbedienung der Fig. 1, und
Fig. 8a und 8b Innenansichten entsprechend der Oberschale und der Unterschale des Kunststoffgehäuses der Fernbedienung der Fig. 1.

In den Figuren werden gleiche technische Elemente mit gleichen Bezugszeichen versehen und nur einmal beschrieben. Die Figuren sind rein schematisch und geben vor allem nicht die tatsächlichen geometrischen Verhältnisse wieder.

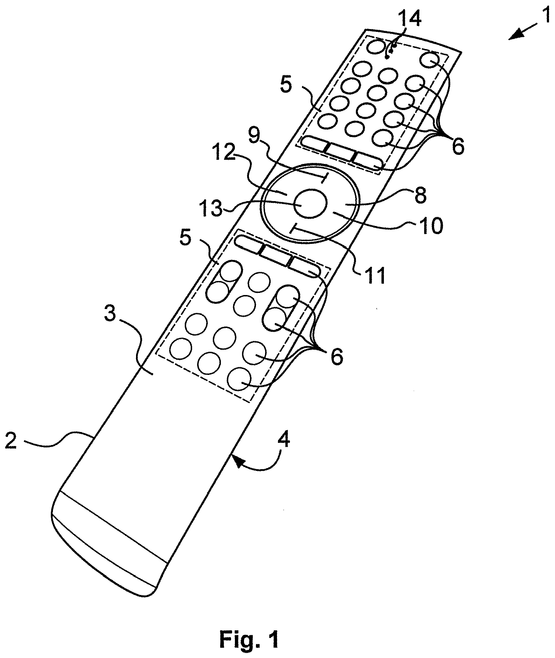

Es wird auf Fig. 1 Bezug genommen, die eine Fernbedienung 1 zur Steuerung eines nicht weiter dargestellten elektronischen Gerätes, wie beispielsweise einem Multimediagerät, in einer perspektivischen Ansicht zeigt.

Die Fernbedienung 1 umfasst ein Kunststoffgehäuse 2, das aus einem ersten Gehäuseteil in Form einer Oberschale 3 und einem zweiten Gehäuseteil Unterschale 4 zusammengesetzt ist, sowie zwei Tastenfelder 5 mit einer Vielzahl von Tastenelementen 6. Von den Tastenelementen 6 im Tastenfeld 5 sind in den Figuren der Übersichtlichkeit halber nicht alle mit einem Bezugszeichen versehen.

Zwischen den beiden Tastenfeldern 5 ist ein Steuerkreuz 8 angeordnet, das ein erstes Tastenelement 9, ein zweites Tastenelement 10, ein drittes Tastenelement 11 und ein viertes Tastenelement 12 umfasst. Die vier Tastenelemente 9 bis 12 sind umfänglich und im Abstand von 90° um eine Bestätigungstaste 13 angeordnet. Das Steuerkreuz 8 mit den vier Tastenelementen 9 bis 12 ist hier als kreisrunde Scheibe ausgebildet. Ferner sind auf der Fernbedienung 1 Rückmeldeelemente 14 in Form kleiner Lämpchen angeordnet, die in Abhängigkeit eines Tastendruckes auf der Fernbedienung 1 aufleuchten können.

Mit der Fernbedienung 1 soll der Betrieb des beispielhaften Multimediagerätes gesteuert werden. Hierzu gibt ein Benutzer mittels der Tasten 5 auf der Oberschale 3 der Fernbedienung 1 Steuerbefehle als Informationen in die Fernbedienung 1 ein, die dann mittels eines nicht weiter gezeigten Übertragers an das zu steuernde elektronische Gerät übertragen werden. Ein derartiger Befehl kann beispielsweise als Richtungsbefehl über die Tastenelemente 9 bis 12 eingegeben werden, der dann die Bewegung eines Steuerelementes auf dem beispielhaften Multimediagerät in eine der vier möglichen Bewegungsrichtungen steuert.

Die Abbildung der Fernbedienung 1 ist lediglich beispielhaft, um die nachstehenden technischen Ausführungen besser verständlich zu gestalten. Sie lassen sich jedoch an jedem beliebigen elektronischen Gerät und insbesondere an jeder beliebigen Fernbedienung umsetzen.

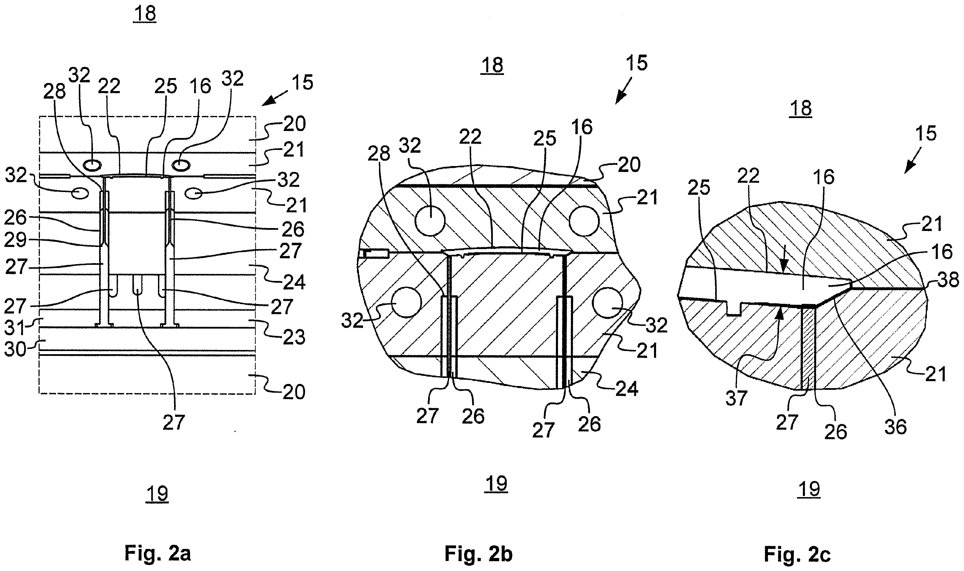

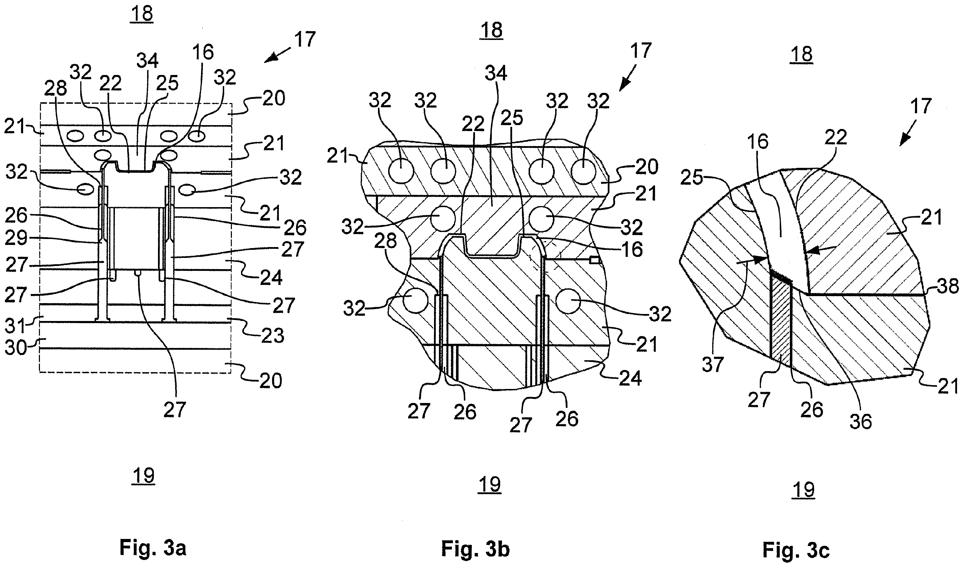

Das Kunststoffgehäuse 2 wird durch Urformen hergestellt, das in den nachstehenden technischen Ausführungen anhand des Spritzgusses erläutert werden soll. In den Fig. 2a bis 2c sind Ausschnitte von Schnittansichten einer Oberschalendauerform 15 gezeigt, die einen Formraum 16 zum Spritzgießen der Oberschale 3 des Kunststoffgehäuses 2 bereitstellen. Demgegenüber sind in den Fig. 3a bis 3c Ausschnitte von Schnittansichten einer Unterschalendauerform 17 gezeigt, die einen dem Formraum 16 zum Spritzgießen der Unterschale 4 des Kunststoffgehäuses 2 bereitstellen.

Die Oberschalendauerform 15 umfasst eine Druckseite 18, die auch Düsenseite 18 genannt wird. Der Druckseite 18 gegenüberliegen umfasst die Oberschalendauerform 15 eine Schließseite 19, die auch Auswerferseite 19 genannt wird. Druckseitig 18 und schließseitig 19 wird die Oberschalendauerform 15 von zwei Aufspannplatten 20 eingeschlossen, auf denen die restlichen Elemente der Oberschalendauerform 15 getragen sind.

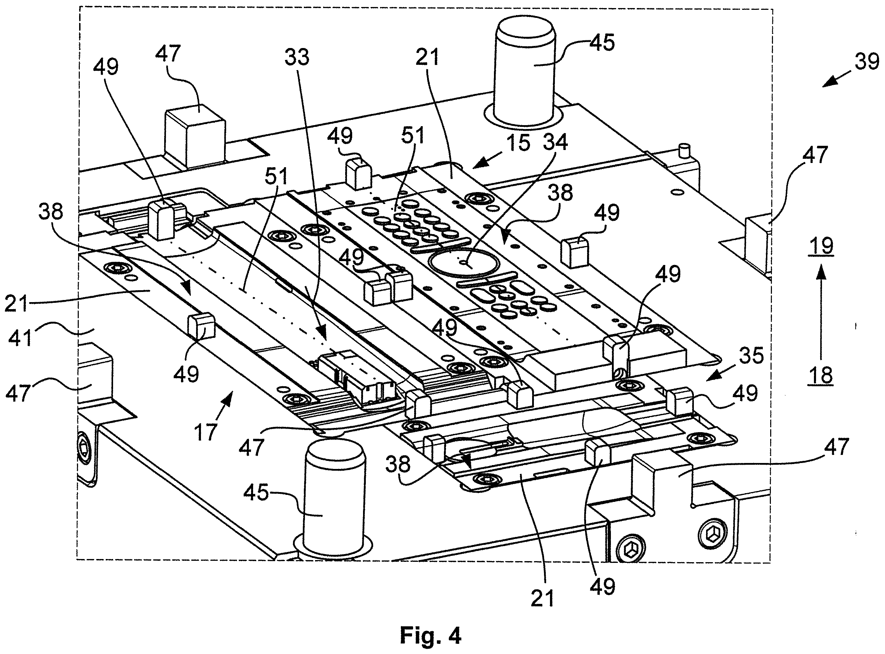

Druckseitig 18 ist auf der Aufspannplatte 20 eine in Fig. 4 gezeigte Formplatte 41 getragen, in die ein Formeinsatz 21 eingelegt ist. In den Formeinsatz 21 ist eine Druckmatrix 22 eingeformt, die die konvexe Außenfläche des Kunststoffgehäuses 2 an der Oberschale 3 bildet.

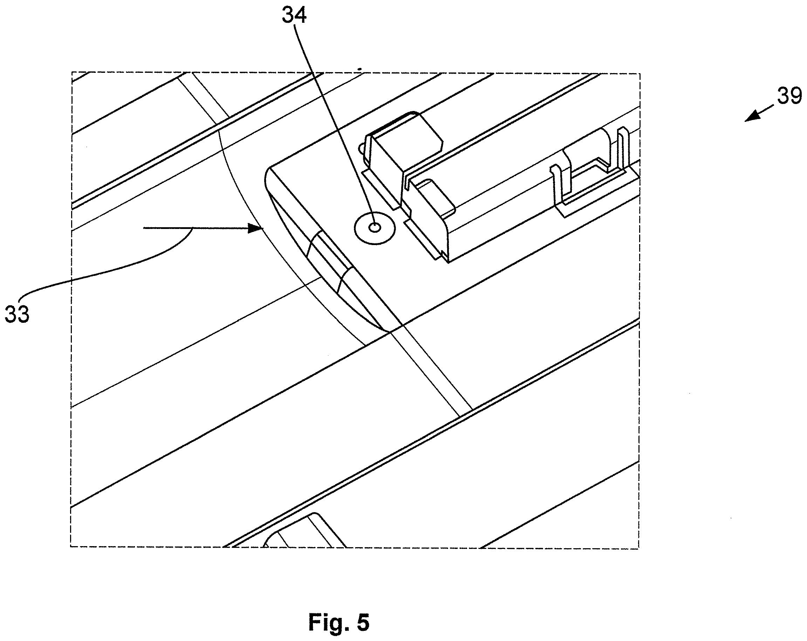

Schließseitig 19 ist auf der Aufspannplatte 20 ein Auswerfergehäuse 23 getragen, das auf der der Aufspannplatte 20 gegenüberliegenden Seite mit einer Druckplatte 24 verschlossen ist. Auf der Druckplatte 24 ist eine in Fig. 5 gezeigte schließseitige Formplatte 41 getragen, in die ein schließseitiger Formeinsatz 21 eingelegt ist. Auf dem schließseitigen Formeinsatz 21 ist ein Kern 25 ausgeformt, der die konkave Innenfläche des Kunststoffgehäuses 2 an der Oberschale 3 bildet.

Die Matrix 22 und der Kern 25 bilden zusammen den Oberschalenformraum 16. In den Oberschalenformraum 16 führen durch die Druckplatte 24 und den schließseitigen Formeinsatz 21 Führungskanäle 26, in denen Auswerferstifte 27 geführt sind. Die Führungskanäle 26 weisen dabei Schultern 28 auf, an denen die Auswerferstifte 27 mit entsprechenden Gegenschultern 29 anschlagen könnten. Von den Schultern 28 und Gegenschultern 29 sind in den Fig. 2a und 2b der Übersichtlichkeit halber nicht alle mit einem Bezugszeichen versehen. Diese Schultern 28, 29 sind konstruktionsbedingt, weil ein oberer Teil der Auswerferstifte 27 als Flachauswerfer ausgeführt ist, während der untere Teil der Auswerferstifte 27 aus Stabilitäts- und Herstellungsgründen rund gefertigt ist, um die Knickbelastbarkeit zu erhöhen. Die Flachausfwerfer der Auswerferstifte 27 sind dabei in den Führungskanälen 26 geführt, während die runden Bereiche der Auswerferstifte 27 unterhalb der Schultern 29 in nicht weiter referenzierten Freibohrungen geführt.

Die Auswerferstifte 27 sind auf einer Auswerfergrundplatte 30 getragen und in ihrer Lage durch eine Auswerferhalteplatte 31 positioniert. Die beiden Platten 30, 31 sind im Inneren des Auswerfergehäuses 23 beweglich angeordnet, so dass über diese die Auswerferstiftte 27 bewegt werden können.

Durch die Druckplatten 21 verlaufen auf der Druckseite 18 als auch auf der Schließseite 19 Temperierbohrungen 32, durch die ein Temperiermittel, wie beispielsweise Wasser geführt werden kann, um den Oberschalenformraum 16 zu durch Kühlen oder Heizen temperieren. Von diesen Temperierbohrungen 32 sind der Übersichtlichkeit halber nicht alle mit einem Bezugszeichen versehen. Die Temperierbohrungen 32 weisen dabei einen Mindestabstand vom Formraum 16 auf, der 10 bis 20 mal kleiner ist, als eine Breite der Oberschale 3 des Kunststoffgehäuses 2. Für den Mindestabstand wurden in der vorliegenden Ausführung 2mm gewählt. Der Durchmesser der Temperierbohrungen 32 ist zwischen 4 und 5 mal so groß, wie der Mindestabstand. Das wären in der vorliegenden Ausführung zwischen 8mm und 10mm. Je größer die Temperierbohrungen 32 sind, desto schneller erfolgt die Temperierung.

Die Unterschalendauerform 17 ist in der selben Weise aufgebaut, wie die Oberschalendauerform 15. Deshalb sind in den Fig. 3a bis 3c die selben Bezugszeichen verwendet, wie in den Fig. 2a bis 2c. Die zuvor ausgeführten Erläuterungen hinsichtlich der Oberschalendauerform 15 gelten für die Unterschalendauerform 17 analog. Deshalb wird auf eine erneute Ausführung hierzu der Kürze halber verzichtet.

Der einzige Unterschied zur Oberschalendauerform 15 ist, dass in der nicht gezeigten Formplatte der Unterschalendauerform 17 auf der Druckseite 18 zwei Formeinsätze 21 eingesetzt sind, die entsprechend mehrere Temperierbohrungen 32 in die Unterschalendauerform 17 einführen.

Die Oberschalendauerform 15 und die Unterschalendauerform 17 können gemeinsam mit einer weiteren, in Fig. 4 und 5 zu sehenden Dauerform 35 zur Herstellung eines Batteriedeckels in einem gemeinsamen Werkzeug angeordnet sein, worauf an späterer Stelle näher eingegangen wird.

Zur Herstellung einer Oberschale 3 und/oder einer Unterschale 4 wird ein variothermes Spritzgussverfahren angewendet. Während üblicherweise beim Spritzguss, insbesondere von Kunststoff unter der Temperierung eine Kühlung verstanden wird, um die Wärmeenergie des geschmolzenen Urformmaterials abzuführen, wird der Formraum 16 bei einem variothermen Spritzgussverfahren vor dem Einspritzen des Urformmaterials zunächst aufgeheizt und danach wieder abgekühlt. Hierbei wird in der vorliegenden Ausführung der Formeinsatz 21 auf der Druckseite 18 als auch auf der Schließseite 19 gleich temperiert, das heißt zunächst aufgewärmt. Auf diese Weise wird insbesondere beim Spritzgießen von Hochglanz-Gehäuseteilen 3, 4 sichergestellt, dass am fertigen Produkt keine Bindenähte auftreten.

Unabhängig vom Aufwärmen wird der entsprechende Formraum 16 geschlossen. Hierzu wird die Aufspannplatte 20 auf der Schließseite 19 gegen die Aufspannplatte 20 auf der Druckseite 18 bewegt, bis sich die beiden Formplatten 21, in denen entsprechend die Matrix 20 und der Kern 25 ausgebildet ist, berühren.

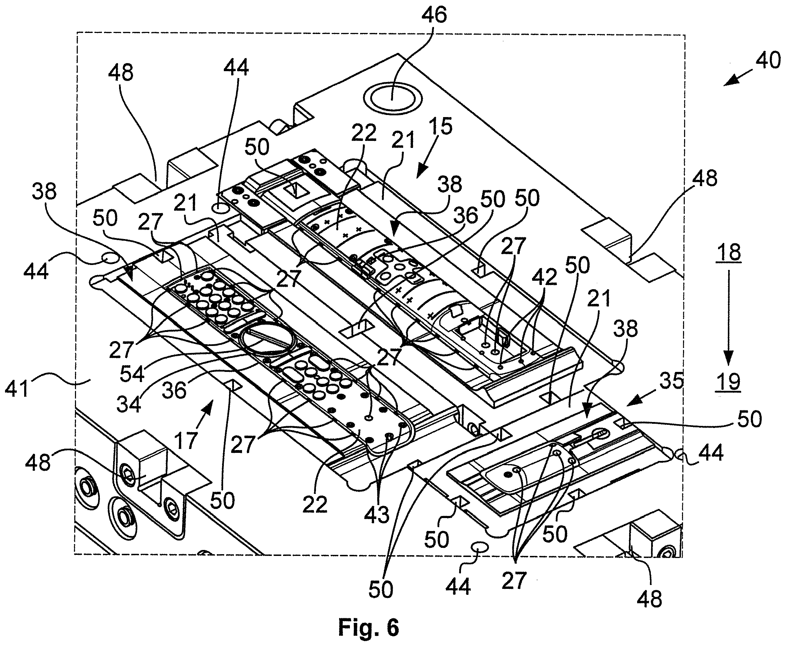

Ist der Formraum 16 geschlossen und entsprechend aufgewärmt, wird das aufgeheizte Urformmaterial über einen in Fig. 5 und 6 zu sehenden Angusskanal 34 in den Formraum 16 eingedrückt. Für ein Hochglanz-Kunststoffgehäuse 2 kann als Urformmaterial für die Schalen 3, 4 Methylmethacrylat-Acrylnitril-Butadien-Styrol, das unter der Abkürzung M-ABS bekannt ist, verwendet werden. Dieses Urformmaterial sollte vor dem Einführen in den Formraum 16 auf 114°C aufgeheizt sein.

Das in den Formraum 16 eingeführte Urformmaterial verteilt sich dort und verdrängt die dort vorhandene Luft. Diese muss dementsprechend abgeführt werden, worauf an späterer Stelle näher eingegangen wird.

Ist der Formraum 16 vollständig mit Urformmaterial ausgefüllt, werden die Formeinsätze 21 über die Temperierbohrungen 32 wieder abgekühlt, so dass sich das Urformmaterial verfestigt. Hierzu wird beispielsweise kaltes Wasser durch die Temperierbohrungen 32 getrieben.

Im Anschluss daran wird der Formraum 16 geöffnet und das so gefertigte Formteil über die Auswerferstifte 27 aus dem Werkzeug ausgestoßen. Hierzu drückt die Auswerfergrundplatte 30 die Auswerferstifte 27 gegen den geöffneten

Formraum 16, so dass sich das dort gefertigte Formteil, also die Oberschale 3 oder die Unterschale 4 löst und so aus dem Werkzeug herausfallen kann. Im Anschluss werden die Auswerferstifte 27 von der Auswerferhalteplatte 31 wieder zurückgezogen, und das gesamte Werkzeug wieder in den Ausgangszustand zurückversetzt, damit der Spritzgußvorgang erneut gestart werden kann.

In der vorliegenden Ausführung soll das Kunststoffgehäuse 2 der Fernbedienung 1 ein möglichst monolithisches Aussehen erhalten. Wenn die Oberschale 3 und die Unterschale 4 daher an einer Fügefläche 36 zusammengesetzt werden, dann soll eine Stoßfuge zwischen den beiden Schalen 3, 4 auf eine Kante fallen, so dass zwischen den beiden Schalen 3, 4 möglichst kein Spalt sichtbar ist. Auf diese Weise wäre es für den Betrachter kaum erkennbar, ob es sich bei dem Kunststoffgehäuse 2 der Fernbedienung 1 um ein einteiliges oder um ein mehrteiliges Bauteil handelt. Die Fernbedienung 1 erhält auf diese Weise ein deutlich schlankeres Aussehen, insbesondere dann, wenn die Oberschale 3 in einem farblichen Kontrast zur Unterschale 4 ausgeführt wird.

Um dies zu erreichen, werden die Fügeflächen 36 an den beiden Schalen 3, 4 derart ausgeführt, dass die beiden Schalen 3, 4 über eine Gehrungsverbindung miteinander verbunden werden können. Daher sollen die Fügeflächen 36 nachstehend als Gehrungsflächen 36 bezeichnet werden. Bei der Herstellung der Gehrungsflächen 36 ist jedoch zu beachten, dass hierdurch an den zu fertigenden Schalen 3, 4 Sprünge in deren Wandstärke 37 auftreten, die zu Fehlern in den Oberflächen der zu fertigenden Schalen 3, 4 führen können. Um den oben genannten monolitischen Effekt bestmöglichst erreichen zu können, müssen die Schalen 3, 4 an den Gehrungsflächen 36 jedoch möglichst spitz zulaufen. Dies bedingt, dass die Wandstärke 37 von einer Normalwandstärke von beispielsweise 2mm auf eine Wandstärke von unter 0,2mm abfällt. Daher muss beim Einsatz des zuvor erläuterten Spritzgussverfahrens darauf geachtet werden, dass aufgrund der großen Sprünge in der Wandstärke 37 die Bildung von Oberflächenfehler, wie Verbrennungen an den Schalen 3, 4 nicht begünstigt wird.

Grundsätzlich kann zu der oben genannten Entlüftung des Formraumes 16 eine Trennebene 38 zwischen den Formeinsätzen verwendet werden. Hierzu müsste jedoch in der Trennebene ein Spalt verbleiben, durch den die Luft aus dem Formraum 16 nach außen entweichen kann. Ist der Formraum 16 jedoch vollständig entlüftet, dann dringt anschließend Urformmaterial dorthin ein, was zur Bildung von Graten führt. Diese Grate kontradiktieren jedoch insbesondere das gewünschte monolithische Erscheinungsbild des Kunststoffgehäuses 2, weshalb eine Entlüftung über die Trennebene 38 ausscheidet.

Aus diesem Grund sind in der vorliegenden Ausführung die Auswerferstifte 27 im Bereich der Gehrungsflächen 36 zur Innenseite des zu fertigenden Kunstoffgehäuses 2 hin angeordnet. Die Führungskanäle 26 und die Auswerferstifte 27 können so derart ausgeführt werden, dass ein ausreichender Spalt zwischen ihnen verbleibt, über den der Formraum 16 entlüftet werden kann.

Vorteil an dieser Lösung ist, dass beim Auswerfen des gefertigten Formteils, also einer der Schalen 3, 4 auch gleichzeitig die Führungskanäle 26 durch die Bewegung der Auswerferstifte 27 gereinigt werden. Zudem kann die Luft beim Auswerfen des gefertigten Formteils aus den Führungskanälen 26 wieder entweichen.

Weiterhin müssen die Formeinsätze 21, die jeweils einen Formraum 16 bilden stets exakt übereinandergesetzt werden, um eine exakt verlaufende Gehrungsfläche 36 zu gewährleisten. Diese Positionierung soll nachstehend anhand der Fig. 4 bis 6 näher erläutert werden, die in einer perspektivischen Ansicht entsprechend eine druckseitige Hälfte 39 und eine schließseitige Hälfte 40 eines Spritzgusswerkzeuges zeigen, in dem die Oberschalendauerform 15, die Unterschalendauerform 17 und die Batteriedeckeldauerform 35 gemeinsam ausgebildet ist. Dabei sind die Formeinsätze 21 der entsprechenden Dauerformen 15, 17 und 35 in den Formplatten 41 gehalten.

In den Kernen 22 der Formeinsätze 21 der schließseitigen Hälfte 40 sind weitere Details zu erkennen, die zur Herstellung der Schalen 3, 4 dienen. So sind beispielsweise in Fig. 5 Zapfenformelemente 42 und Hülsenformelemente 43 zu erkennen, mit denen die Schalen 3, 4 mit Zapfen und Hülsen gemäß der technischen Lehre der DE 10 2010 045 944 A1 ausgebildet werden können, um das Kunststoffgehäuse 2 möglichst schraubenfrei verschließen zu können. Von diesen Zapfenformelementen 42 und Hülsenformelementen 43 sind in Fig. 5 nicht alle mit einem eigenen Bezugszeichen versehen.

Weiter sind in Fig. 5 zusätzliche Rücksetzelemente 44 zu erkennen, mit denen die beiden Häften 39, 40 nach dem Erkalten der Urformmassen für die herzustellenden Schalen 3, 4 in den Formräumen 16 auseinander gedrückt werden können. Um die beiden Hälften 39, 40 bei dieser Bewegung gegeneinander zu führen, sind an der druckseitigen Hälfte 39 Führungssäulen 45 befestigt, die in entsprechende Führungsbohrungen 46 auf der schließseitigen Hälfte 40 einführbar sind.

Die oben genannten Angusskanäle 34 sind in den Fig. 4 und 5 gezeigt, wobei die Ansicht 33 in Fig. 5 durch einen Pfeil in Fig. 4 angedeutet ist. Der Angusskanal 34 der Oberschalendauerform 15 mündet in einen Stauboden 54 auf der schließseitigen Hälfte 40. In dem Stauboden 54 sammelt sich das zu verarbeitende Urformmaterial und wird umgelenkt, so dass das Urformmaterial aus dem Angußkanal 34 für die zu fertigende Oberschale 3 winklig zu seiner Ausstoßrichtung austritt. Auf diese Weise wird der Angusskanal 34 als Tunnelanschnitt und die Oberschalendauerform 15 als Abreißspritzgießform ausgeführt.

Um die zuvor genannte exakte Lage der Formeinsätze 21 und damit die exakte Ausbildung der Formräume 16 sicherzustellen, sind die Hälften 39, 40 mit einer doppelten Zentrierung versehen. Eine erste Zentrierung zentriert die beiden Hälften 39, 40 gegeneinander grob. Hierzu sind an der druckseitigen Hälfte 39 Werkzeugzentrierzapfen 47 angeschraubt, die beim Schließen des Formraumes 16 in entsprechende Werkzeugzentrieraufnahmen 48 an der schließseitigen Hälfte 40 eingreifen. Zur Feinzentrierung sind ferner an den Formeinsätzen 21 an der druckseitigen Hälfte 39 Formeinsatzzentrierzapfen 49 ausgebildet, die in Formeinsatzzentrieraufnahmen 50 in den Formeinsätzen 21 der schließseitigen Hälfte 40 einführbar sind.

Die Formeinsatzzentrierzapfen 49 sind dabei kleiner ausgeführt, als die Werkzeugzentrierzapfen 47, so dass beim Schließen des Formraumes 16 zunächst die grobe Zentrierung wirkt, und erst wenn diese weitestgehend abgeschlossen ist, die Feinzentrierung zum Einsatz kommt.

Zur weiteren Reduktion von potentiellen Oberflächenfehlern auf den Schalen 3, 4 des Kunststoffgehäuses 2 werden die Angusskanäle 34 und damit die Anspritzpunkte auf Mittelachsen 51 der Formräume 16 angeordnet, so dass das Urformmaterial nach dem Eindringen in den jeweiligen Formraum 16 sich dort gleichmäßig ausbreiten und verteilen kann. Zudem ist dadurch sichergestellt, dass das Urformmaterial in die Randzonen mit den oben genannten Sprüngen in der Wandstärke 37, die die Gehrungsflächen 36 bilden, zuletzt vordringt und diese Bereiche des Formraumes 16 gleichmäßig ausfüllt. Weiterhin ist so sichergestellt dass das Urformmaterial nahe des Angusskanals 34 aufgrund eines zu dünnen Formraumbereichs nicht vorzeitig aushärtet.

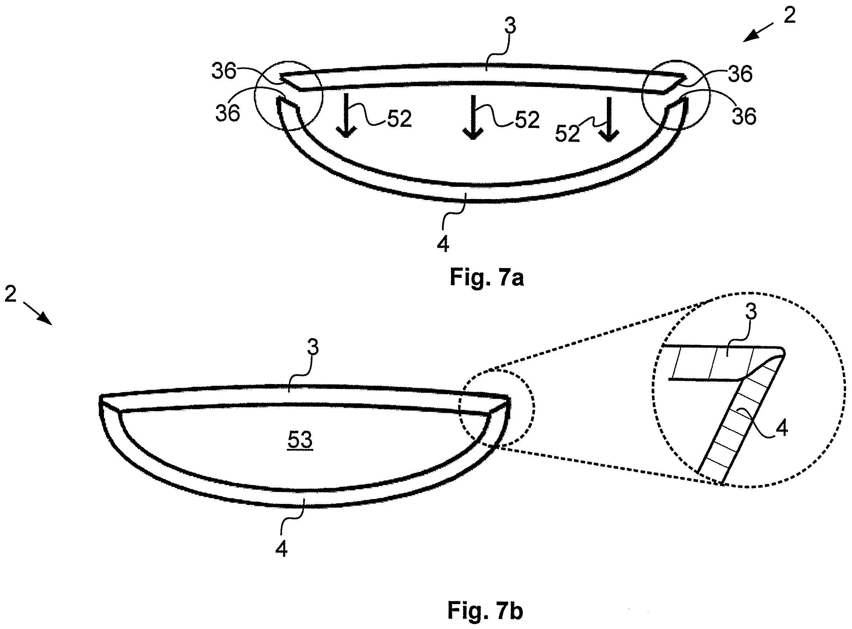

Die mit dem zuvor beschriebenen Werkzeug und Verfahren hergestellten Schalen 3, 4 können nach dem Auswerfen aus dem Werkzeug in einer in Fig. 7a angedeuteten Weise in einer Fügerichtung 52 zu dem Kunststoffgehäuse 2 zusammengesetzt werden und so einen in Fig. 7b angedeuteten Innenraum 53 einhausen, in dem beispielsweise eine nicht weiter gezeigte Leiterplatte als Elektronik der Fernbedienung 1 aufgenommen werden kann.

Beim Zusammensetzen von Oberschale 3 und Unterschale 4 in der Fügerichtung 52 werden die beiden Schalen 3, 4 dabei an den Gehrungsflächen 36 automatisch zentriert. Auf diese Weise sind ein in Fig. 7b gezeigter bündiger Abschluss zwischen Oberschale 3 und Unterschale 4 nach außen hin und somit die zuvor erwähnte monolithisch wirkende Form des Kunststoffgehäuses 2 sichergestellt.

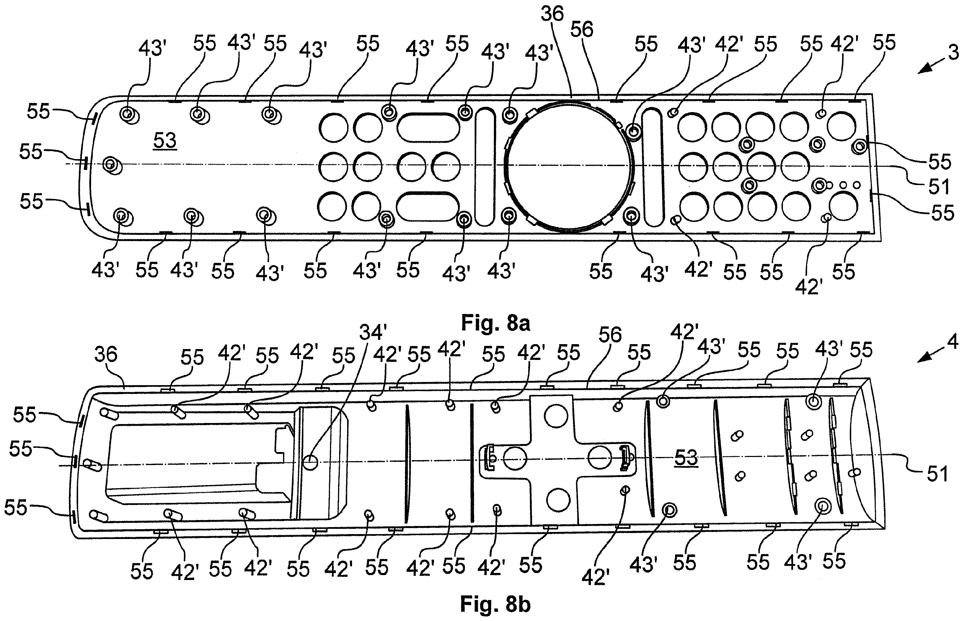

Ein Beispiel für eine Innenansicht der hergestellten Oberschalen 3 und Unterschalen 4 ist entsprechend in Fig. 8a und 8b gezeigt. Damit entspricht die Ansicht der Fig. 8a und 8b dem, was mit der schließseitigen Hälfte 40 der Werkzeugformen gebildet wird.

Deutlich zu sehen sind Auflageflächen 55, an denen die Auswerferstifte 27 angreifen, um entsprechend die Oberschale 3 oder Unterschale 4 aus der schließseitgen Hälfte 40 auszustoßen. Die Auswerferstifte 27 und damit die Auflageflächen 55 sind rechteckförmig ausgebildet, wobei die Breitseite der Rechteckform sich in Umfangsrichtung um die Oberschale 3 oder Unterschale 4 erstreckt.

Die Auswerferstifte 27 und damit die Auflageflächen 55 sind an einer zum Innenraum 53 hin gerichteten Kante 56 der Oberschale 3 oder Unterschale 4 angeordnet. Auf diese Weise wird sichergestellt, dass die Außenkanten der beiden Schalen 3, 4 bündig schließen und so das monolithische Erscheinungsbild der Fernbedienung nicht gestört wird.

Durch die Auswerferstifte 27 können die Schalen 3, 4 an den Auflageflächen 55 vertieft sein.

In den Fig. 8a und 8b sind ferner noch entsprechend durch die Zapfenformelemente 42 und Hülsenformelemente 43 gebildete Zapfen 42' und Hülsen 43' abgebildet, von denen der Übersichtlichkeit halber nicht alle mit einem eigenen Bezugszeichen versehen sind. Ferner ist in Fig. 8b die Stelle 34' zu sehen, an der der Angusskanal 34 für die Unterschale 4 endete. Die entsprechende Stelle 34' an der Oberschale ist in der Perspektive der Fig. 8a nicht zu sehen.

## Patentansprüche

1. Kunststoffgehäuse (2) für elektronische Geräte (1), insbesondere Fernbedienungen, mit einem ersten Gehäuseteil (3) und einem zweiten Gehäuseteil (4), wobei das erste Gehäuseteil (3) eine in Richtung des zweiten Gehäuseteils (4) gerichtete Fügefläche (36) umfasst und das zweite Gehäuseteil (4) eine in Richtung des ersten Gehäuseteils (3) gerichtete Fügefläche (36) umfasst, wobei die beiden Gehäuseteile (3, 4) den Fügeflächen (36) aneinander anliegend zusammengesetzt sind, und wobei die Fügeflächen (36) als Gehrungsflächen (36) ausgeführt sind, **dadurch gekennzeichnet, dass** an oder auf den Gehrungsflächen (36) Auflageflächen (55) zur Auflage von Auswerferstiften (27) ausgebildet sind an denen die Gehäuseteile (3, 4) vertieft sind.

2. Kunststoffgehäuse (2) nach Anspruch 1, wobei die Gehrungsflächen (36) der Gehäuseteile (3, 4) zumindest teilweise umlaufend um einen Innenraum (53) ausgebildet sind, der eingerichtet ist, eine elektronische Komponente des elektronischen Gerätes (1) einzuhausen.

3. Kunststoffgehäuse (2) nach Anspruch 1 oder 2, wobei die Gehrungsflächen (36) in den Innenraum (53) hinein führend ausgebildet sind.

4. Kunststoffgehäuse (2) nach nach einem der vorstehenden Ansprüche, wobei die Auflageflächen (55) rechteckförmig mit einer Längsseite ausgebildet sind, die sich in Umfangsrichtung der Gehäuseteile (3, 4) erstreckt.

5. Kunststoffgehäuse (2) nach nach einem der vorstehenden Ansprüche, wobei die Gehäuseteile (3, 4) an den Auflageflächen (55) eine Vertiefung aufweisen.

6. Kunststoffgehäuse (2) nach einem der vorstehenden Ansprüche, wobei die Auflageflächen (55) an den Gehrungsflächen (36) an einer zum Innenraum (53) gerichteten Kante (56) der Gehrungsflächen (36) ausgebildet sind

7. Kunststoffgehäuse (2) nach einem der vorstehenden Ansprüche, das durch ein Verfahren hergestellt ist, bei dem ein Urformmaterial in die Gehäuseteile (3, 4) bildenden Formräume (16) eingeführt und Luft aus dem den Formräumen (16) an Eintlüftungsstellen (26) abgeführt wird, die an oder neben Stellen in den Formräumen (16) liegt, an der die Gehrungsflächen (36) der Gehäuseteile (3, 4) gebildet werden.

8. Kunststoffgehäuse (2) nach Anspruch 7, wobei zum Abführen der Luft aus den Formräumen (16) in die Formräume (16) führende Kanäle (26) genutzt werden, in denen Auswerferstifte (27) eingeführt sind.

9. Kunststoffgehäuse (2) nach Anspruch 7 oder 8, wobei das Urformmaterial an Anspritzpunkten (34) in die Formräume (16) eingeführt wird, die an einer Seite des Formraumes (16) angeordnet ist, der einer Seite mit der Entlüftungsstelle (27) gegenüberliegt.

10. Kunststoffgehäuse (2) nach Anspruch 9, wobei die Anspritzpunkte (34) auf einer Mittelachse (51) in den Formräumen (16) angeordnet sind.

11. Kunststoffgehäuse (2) nach einem der vorstehenden Ansprüche 7 bis 10, wobei die Formräume (16) mit Formeinsätzen (21) gebildet werden, die vor dem Einführen des Urformmaterials in die Formräume (16) an einer Trennebene (38) luftdicht verschlossen werden.

12. Kunststoffgehäuse (2) nach Anspruch 11, wobei die Gehrungsflächen (36) der zu bildenden Gehäuseteile (3, 4) in die Trennebene (38) münden.

13. Kunststoffgehäuse nach Anspruch 12, wobei die Entlüftungsstellen (27) an den Gehrungsflächen (36) der Trennebene (38) gegenüberliegen.

## Claims

1. Plastic housing (2) for electronic devices (1), in particular remote controls, comprising a first housing part (3) and a second housing part (4), wherein the first housing part (3) has a joining surface (36) facing the second housing part (4), and the second housing part (4) has a joining surface facing the first housing part (3), wherein the two housing parts (3, 4) are assembled such that the joining surfaces (36) rest against each other, and wherein the joining surfaces (36) are in the form of mitred surfaces (36), **characterized in that** contact surfaces (55) to support ejector pins (27) are formed at or on the mitred surfaces (36), where the housing parts (3, 4) are recessed.

2. Plastic housing (2) as claimed in claim 1, wherein the mitred surfaces (36) of the housing parts (3, 4) are formed at least in part so as to revolve around an interior space (53) which is designed to enclose an electronic component of the electronic device (1).

3. Plastic housing (2) as claimed in claim 1 or 2, wherein the mitred surfaces (36) are formed so as to lead into the interior space (53).

4. Plastic housing (2) as claimed in one of the preceeding claims, wherein the contact surfaces (55) are formed so as to be rectangular with a longitudinal side extending in the circumferential direction of the housing parts (3, 4).

5. Plastic housing (2) as claimed in one of the preceeding claims, wherein the housing parts (3, 4) have a depression on the contact surfaces (55).

6. Plastic housing (2) as claimed in one of the preceding claims, wherein the contact surfaces (55) are formed on the mitred surfaces (36) on an edge (56) of the mitred surfaces (36) facing the interior space (53).

7. Plastic housing (2) as claimed in one of the preceding claims, which is produced by a method in which a casting material is introduced into the mould cavities (16) forming the housing parts (3, 4), and air is removed from the mould cavities (16) at the deaeration points (26) which are positioned at or next to points in the mould cavities (16), at which the mitred surfaces (36) of the housing parts (3, 4) are formed.

8. Plastic housing (2) as claimed in claim 7, wherein channels (26) leading into the mould cavities (16), into which channels ejector pins (27) are inserted, are used to remove the air from the mould cavities (16).

9. Plastic housing (2) as claimed in claim 7 or 8, wherein the casting material is introduced into the mould cavities (16) at injection points (34) which are arranged on a side of the mould cavity (16) opposite the side having the deaeration point (27).

10. Plastic housing (2) as claimed in claim 9, wherein the injection points (34) are arranged on a central axis (51) in the mould cavities (16).

11. Plastic housing (2) as claimed in one of the preceding claims 7 to 10, wherein the mould cavities (16) are formed with mould inserts (21) which are closed in an airtight manner at a parting plane (38) before the casting material is injected into the mould cavities (16).

12. Plastic housing (2) as claimed in claim 11, wherein the mitred surfaces (36) of the housing parts (3, 4) to be formed lead into the parting plane (38).

13. Plastic housing as claimed in claim 13, wherein the deaeration points (27) on the mitred surfaces (36) are opposite the parting plane (38).

## Revendications

1. Boîtier en matière plastique (2) pour les dispositifs électroniques (1), en particulier pour les télécommandes, comprenant une première partie de boîtier (3) et une deuxième partie de boîtier (4), dans lequel la première partie de boîtier (3) comprend une surface de jonction (36) dirigée dans la direction de la deuxième partie de boîtier (4) et la deuxième partie de boîtier (4) comprend une surface de jonction (36) dirigée dans la direction de la première partie de boîtier (3), dans lequel les deux parties de boîtier (3, 4) sont assemblées avec les surfaces de jonction (36) adjacentes l'une contre l'autre, et dans lequel les surfaces de jonction (36) sont conçues sous forme de surfaces en onglet (36), **caractérisé en ce que** contre ou sur les surfaces en onglet (36) sont formées des surfaces de contact (55) pour le support de broches d'éjection (27) sur lesquelles sont encastrées les parties de boîtier (3, 4).

2. Boîtier en matière plastique (2) selon la revendication 1, dans lequel les surfaces en onglet (36) des parties de boîtier (3, 4) sont formées au moins partiellement circonférentiellement autour d'un espace intérieur (53) qui est agencé pour loger un composant électronique du dispositif électronique (1).

3. Boîtier en matière plastique (2) selon la revendication 1 ou 2, dans lequel les surfaces en onglet (36) sont conçues pour pénétrer dans l'espace intérieur (53).

4. Boîtier en matière plastique (2) selon l'une quelconque des revendications précédentes, dans lequel les surfaces de contact (55) sont rectangulaires avec un côté longitudinal qui s'étend dans la direction circonférentielle des parties de boîtier (3, 4).

5. Boîtier en matière plastique (2) selon l'une quelconque des revendications précédentes, dans lequel. les parties de boîtier (3, 4) présentent une dépression sur les surfaces de contact (55).

6. Boîtier en matière plastique (2) selon l'une quelconque des revendications précédentes, dans lequel les surfaces de contact (55) sur les surfaces en onglet (36) sont formées sur un bord (56) des surfaces en onglet (36) qui est dirigé vers l'espace intérieur (53).

7. Boîtier en matière plastique (2) selon l'une quelconque des revendications précédentes, produit par un procédé dans lequel un matériau de base de moulage est introduit dans des espaces de moule (16) formant les parties de boîtier (3, 4) et de l'air est évacué hors des espaces de moule (16) par des orifices de purge d'air (26) situés dans les espaces de moule (16) sur ou à proximité d'emplacements où sont formées les surfaces en onglet (36) des parties de boîtier (3, 4).

8. Boîtier en matière plastique (2) selon la revendication 7, dans lequel pour évacuer l'air hors des espaces de moule (16) on utilise des conduits (26) menant dans les espaces de moule (16), dans lesquels sont insérées des broches d'éjection (27).

9. Boîtier en matière plastique (2) selon la revendication 7 ou 8, dans lequel le matériau de base de moulage est introduit dans les espaces de moule (16) selon un point d'injection (34), qui est disposé selon un côté de l'espace de moule (16) qui est opposé à un côté ayant le point de purge d'air (27).

10. Boîtier en matière plastique (2) selon la revendication 9, dans lequel les points d'injection (34) sont disposés sur un axe central (51) dans les espaces de moule (16).

11. Boîtier en matière plastique (2) selon l'une quelconque des revendications précédentes 7 à 10, dans lequel les espaces de moule (16) sont formés avec des inserts de moule (21) qui sont hermétiquement scellés dans un plan de joint (38) avant que le matériau de base de moulage ne soit introduit dans les espaces de moule (16).

12. Boîtier en matière plastique (2) selon la revendication 11, dans lequel les surfaces en onglet (36) des parties de boîtier (3, 4) à former débouchent dans le plan de joint (38).

13. Boîtier en matière plastique (2) selon la revendication 12, dans lequel les points de purge d'air (27) sur les surfaces en onglet (36) sont en regard du plan de joint (38).
